# EUROPEAN PATENT APPLICATION

(11) **EP 4 733 788 A1**
(43) Date of publication of application: **29.04.2026**
(21) Application number: 25768585.9
(22) Date of filing: 06.03.2025
(51) Int. Cl.: G01R 31/392, G01R 31/3842, G01R 31/3828, G01R 31/367, B60L 58/16

(54) **APPARATUS AND METHOD FOR MANAGING BATTERY**

(30) Priority: 08.03.2024 KR 20240033300
(71) Applicant: LG Energy Solution, Ltd., Seoul 07335 (KR)
(72) Inventor: KIM, An-Soo, Daejeon 34122 (KR)
(74) Representative: Plasseraud IP
(86) International application number: PCT/KR2025/099603
(87) International publication number: WO 2025/188166

(57) **Abstract**

The battery management apparatus according to an embodiment of the present disclosure includes a measuring unit configured to measure voltage and current of a battery bank during a charging process of the battery bank including a plurality of battery cells; and a control unit configured to estimate a first SOH of the battery bank based on a charging capacity obtained by integrating the measured current, determine a second SOH based on a time during which a circulating current flows through the plurality of battery cells from a charging end point of the battery bank, and estimate a SOH of the battery bank based on the first SOH and the second SOH.

## Description

### TECHNICAL FIELD

This application is based on and claims priority from Korean Patent Application No. 10-2024-0033300, filed on March 8, 2024, with the Korean Intellectual Property Office, the disclosure of which is incorporated herein in its entirety by reference.

The present disclosure relates to a battery management apparatus and method, and more specifically, to a battery management apparatus and method capable of estimating a state of a battery more accurately.

### BACKGROUND ART

Recently, as the demand for portable electronic products such as laptops, video cameras, and mobile phones has increased rapidly and the development of electric vehicles, energy storage batteries, robots, and satellites has become full-fledged, research on high-performance batteries capable of repeated charging and discharging is actively being conducted.

Currently commercialized batteries include nickel cadmium batteries, nickel hydrogen batteries, nickel zinc batteries, and lithium batteries. Among these, lithium batteries are receiving attention due to their advantages such as the fact that they have almost no memory effect compared to nickel-based batteries, are free to charge and discharge, have a very low self-discharge rate, and have high energy density.

Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve the problems of the related art, and therefore the present disclosure is directed to providing a battery management apparatus and method capable of more accurately estimating a SOH (State of health) and a SOC (State of charge) of a battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a measuring unit configured to measure voltage and current of a battery bank during a charging process of the battery bank including a plurality of battery cells; and a control unit configured to estimate a first SOH of the battery bank based on a charging capacity obtained by integrating the measured current, determine a second SOH based on a time during which a circulating current flows through the plurality of battery cells from a charging end point of the battery bank, and estimate a SOH of the battery bank based on the first SOH and the second SOH.

The control unit may be configured to calculate a charging capacity of the battery bank by integrating the measured current and estimate the first SOH of the battery bank based on the calculated charging capacity.

The control unit may be configured to calculate the time at which the circulating current flows based on the voltage of the battery bank from the charging end point.

The control unit may be configured to determine the second SOH corresponding to the time using an SOH table in which a SOH value corresponding to the time at which the circulating current flows is preset.

The control unit may be configured to determine the second SOH corresponding to the voltage of the battery bank at the charging end point and the time by using an SOH table in which the time at which the circulating current flows and a SOH value corresponding to a voltage of the battery bank after the circulating current flows are preset.

The control unit may be configured to generate a third SOH by calculating a difference between the first SOH and the second SOH and estimate the generated third SOH as the SOH of the battery bank.

The control unit may be configured to determine the second SOH when a difference between the first SOH and a previously estimated SOH of the battery bank is greater than or equal to a preset threshold value.

The plurality of battery cells may be configured to be connected in parallel with each other.

A battery pack according to another aspect of the present disclosure may comprise the battery management apparatus according to an aspect of the present disclosure.

A vehicle according to still another aspect of the present disclosure may comprise the battery management apparatus according to an aspect of the present disclosure.

A battery management method according to still another aspect of the present disclosure may comprise: a measuring step of measuring voltage and current of a battery bank during a charging process of the battery bank including a plurality of battery cells; a first SOH estimating step of estimating a first SOH of the battery bank based on a charging capacity obtained by integrating the measured current; a second SOH determining step of determining a second SOH based on a time during which a circulating current flows through the plurality of battery cells from a charging end point of the battery bank; and a SOH estimating step of estimating a SOH of the battery bank based on the first SOH and the second SOH.

### Advantageous Effects

According to one aspect of the present disclosure, there is an advantage in that the SOH of a battery bank may be estimated more accurately by considering the time during which a circulating current flows between a plurality of battery cells.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically of a battery management apparatus according to an embodiment of the present disclosure.
FIG. 2 is a schematic drawing of a battery bank according to an embodiment of the present disclosure.
FIG. 3 is a schematic drawing of an SOH table according to an embodiment of the present disclosure.
FIG. 4 is a schematic drawing of an SOH table according to another embodiment of the present disclosure.
FIG. 5 is a schematic drawing of a battery pack according to another embodiment of the present disclosure.
FIG. 6 is a schematic drawing of a vehicle according to still another embodiment of the present disclosure.
FIG. 7 is a schematic drawing of an ESS according to still another embodiment of the present disclosure.
FIG. 8 is a diagram schematically of a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

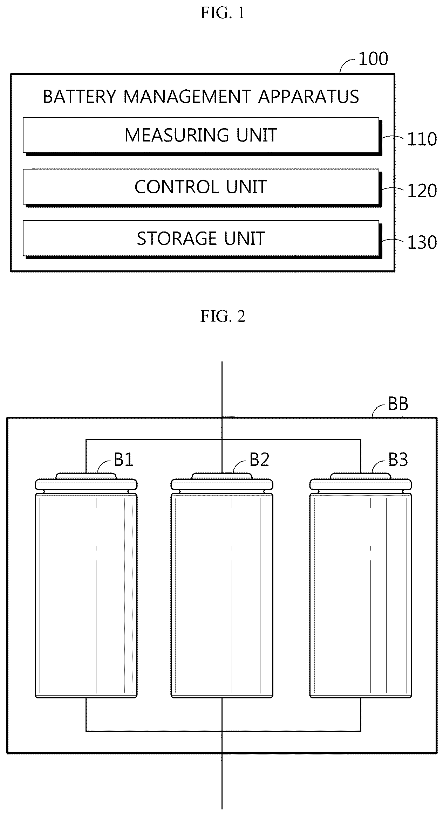

FIG. 1 is a diagram schematically showing a battery management apparatus 100 according to an embodiment of the present disclosure.

Referring to FIG. 1, the battery management apparatus 100 may include a measuring unit 110 and a control unit 120.

The measuring unit 110 may be configured to measure voltage and current of a battery bank BB during a charging process of the battery bank BB including a plurality of battery cells.

Here, a battery cell means a physically separable independent cell including a negative electrode terminal and a positive electrode terminal. For example, a lithium-ion battery or a lithium polymer battery may be considered a battery cell. Additionally, the type of battery may be cylindrical type, prismatic type, or pouch type. In addition, the battery bank may include a plurality of battery cells connected in parallel with each other. The configuration including a plurality of cells may be expressed as a battery bank, a battery module, or a battery pack.

FIG. 2 is a schematic drawing of a battery bank BB according to an embodiment of the present disclosure.

For example, in the embodiment of FIG. 2, the battery bank BB may include a first battery cell B1, a second battery cell B2, and a third battery cell B3. And, the first battery cell B1, the second battery cell B2, and the third battery cell B3 may be connected in parallel with each other.

The measuring unit 110 has one end connected to the positive electrode terminal of the battery bank BB, and may measure the positive electrode potential of the battery bank BB. Then, the measuring unit 110 has the other end connected to the negative electrode terminal of the battery bank BB, and may measure the negative electrode potential of the battery bank BB. Then, the measuring unit 110 may measure the voltage of the battery bank BB based on the difference between the positive electrode potential and the negative electrode potential.

In addition, the measuring unit 110 may be connected to the charging and discharging path of the battery bank BB to measure the charging and discharging current of the battery bank BB. For example, the measuring unit 110 may be connected to a current measurement unit provided in the current path of the battery bank BB to measure the charging current applied to the battery bank BB and the discharging current output from the battery bank BB.

The control unit 120 may be configured to estimate the first SOH of the battery bank BB based on the charging capacity obtained by integrating the measured current.

First, the control unit 120 may be configured to calculate the charging capacity of the battery bank BB by integrating the measured current. For example, the control unit 120 may calculate the charging capacity of the battery bank BB during the charging process by integrating the current measured by the measuring unit 110 from the charging start point to the charging end point of the battery bank BB. Here, the control unit 120 may calculate the charging capacity of the battery bank BB by using the current integrating method (Coulomb counting, Ampere counting).

The control unit 120 may be configured to estimate the first SOH of the battery bank BB based on the calculated charging capacity. Specifically, the control unit 120 may estimate the first SOH of the battery bank BB by calculating a ratio of the charging capacity to a preset reference capacity. Here, the reference capacity may be preset to correspond to the initial capacity of the battery bank BB. For example, the reference capacity may be preset to the capacity of the battery bank BB in the BOL (Beginning of life) state.

In the embodiment of FIG. 2, the control unit 120 may calculate the charging capacity based on the current of the battery bank BB measured by the measuring unit 110. Then, the control unit 120 may estimate the first SOH of the battery bank BB by calculating a ratio between a reference capacity preset to correspond to the battery bank BB and the calculated charging capacity. For example, the control unit 120 may estimate the first SOH of the battery bank BB by calculating a formula of "calculated charging capacity ÷ preset reference capacity."

The control unit 120 may be configured to determine the second SOH based on the time during which a circulating current flows through the plurality of battery cells from the charging end point of the battery bank BB.

Specifically, the control unit 120 may be configured to calculate the time during which the circulating current flows based on the voltage of the battery bank BB from the charging end point.

More specifically, the measuring unit 110 may measure the voltage of the battery bank BB according to the measurement cycle even after the charging of the battery bank BB is terminated. In addition, the control unit 120 may calculate the time during which the circulating current flows through the plurality of battery cells based on the voltage of the battery bank BB at the charging end point and the voltage of the battery bank BB measured by the measuring unit 110 after the charging is terminated.

In general, if the degradation degrees of the battery cells connected in parallel are different, the capacities of the plurality of battery cells may be different immediately after the charging of the battery bank BB is terminated. In this case, the capacities and voltages are balanced as the circulating current flows between the plurality of battery cells. This phenomenon is called self-balancing or self-energy balancing.

Since this circulating current is generated by the voltage difference between the plurality of battery cells, the voltage of the battery bank BB may change while the circulating current flows even after charging is completed. That is, during the time when the voltage of battery bank BB changes from the charging end point of the battery bank BB, the circulating current may flow between the plurality of battery cells. Accordingly, the control unit 120 may calculate the time from the charging end point of the battery bank BB to the time when the voltage change of the battery bank BB is completed as the time during which the circulating current flows through the plurality of battery cells.

Here, since the circulating current is a current that flows directly between the plurality of battery cells, it is noted that the time at which the circulating current flows between the plurality of battery cells and the time at which the plurality of battery cells reach a rest state (e.g., a state in which the OCV (open circuit voltage) can be measured) are different times.

The control unit 120 may be configured to determine the second SOH using an SOH table in which an SOH value corresponding to the time at which a circulating current flows is preset.

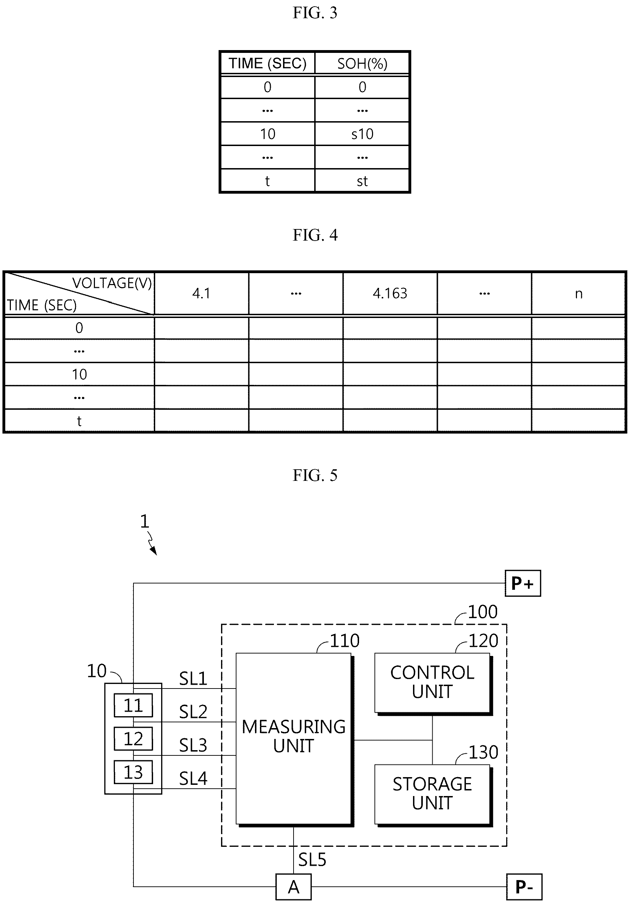

FIG. 3 is a schematic drawing schematically showing an SOH table according to an embodiment of the present disclosure. For example, the SOH table may preset a corresponding SOH value for each time at which a circulating current flows. In the embodiment of FIG. 3, when the time is 0 second, the SOH value is 0% because no circulating current flows between the plurality of battery cells.

Specifically, the control unit 120 may determine the SOH value corresponding to the calculated time using the SOH table. Then, the control unit 120 may determine the determined SOH value as the second SOH for the battery bank BB. Here, the second SOH may be a correction value used to correct the estimated first SOH for the battery bank BB. In other words, the second SOH is a value that converts the difference in degradation degrees between the plurality of battery cells into SOH. In other words, the second SOH is an internal error value for correcting the SOH of the battery bank BB.

Preferably, the second SOH may be proportional to the time during which the circulating current flows. For example, as the difference in the degradation degrees between the plurality of battery cells increases, the time during which the circulating current flows between the plurality of battery cells may increase. Accordingly, as the time during which the circulating current flows increases, the second SOH value for the battery bank BB may increase.

For example, in the embodiment of FIG. 2, it is assumed that a circulating current flows in the battery bank BB for t seconds. The control unit 120 may determine an SOH value corresponding to t seconds from the SOH table, and determine the determined SOH value as the second SOH for the battery bank BB.

The control unit 120 may be configured to estimate the SOH of the battery bank BB based on the first SOH and the second SOH.

Specifically, the control unit 120 may be configured to calculate the difference between the first SOH and the second SOH to calculating a third SOH, and estimate the calculated third SOH as the SOH of the battery bank BB.

For example, the control unit 120 may calculate the formula of "first SOH - second SOH" to calculate the third SOH, and estimate the calculated third SOH as the SOH of the battery bank BB.

In the embodiment of FIG. 2, the control unit 120 may estimate the first SOH of the battery bank BB by calculating the charging capacity of the battery bank BB, and determine the second SOH according to the time at which the circulating current flows between the plurality of battery cells B1, B2, B3. In addition, the control unit 120 may estimate the SOH of the battery bank BB by calculating the difference between the first SOH and the second SOH.

The battery management apparatus 100 according to an embodiment of the present disclosure may estimate the SOH of the battery bank BB more accurately by correcting the SOH of the battery bank BB by considering internal error of the battery bank BB (difference in degradation degrees between the plurality of battery cells).

That is, the first SOH estimated by integrating the charging current may not reflect the state difference between the plurality of battery cells included in the battery bank BB. Therefore, the battery management apparatus 100 may estimate the SOH of the battery bank BB more accurately by correcting the first SOH of the battery bank BB using the second SOH based on the difference between the plurality of battery cells.

Meanwhile, the control unit 120 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store the voltage and current of the battery bank BB measured by the SOH measuring unit 110. In addition, the storage unit 130 may store the SOH table. The control unit 120 may access the storage unit 130 to secure the SOH table. In addition, the storage unit 130 may store information estimated or determined by the control unit 120.

The control unit 120 may be configured to determine a second SOH corresponding to the voltage and time of the battery bank BB at the charging end point by using an SOH table in which the time at which the circulating current flows and an SOH value corresponding to the voltage of the battery bank BB after the circulating current flows are preset.

FIG. 4 is a schematic drawing schematically showing an SOH table according to another embodiment of the present disclosure. For example, the SOH table may preset a corresponding SOH value for the time at which the circulating current flows and the voltage of the battery bank BB.

Similar to the embodiment of FIG. 3, in the embodiment of FIG. 4, if the time is 0 second, no circulating current flows between the plurality of battery cells, and therefore, the SOH value is 0%. For example, in the embodiment of FIG. 4, if the time during which the circulating current flows is 10 seconds and the voltage of the battery bank BB is 4.163 [V], the second SOH may be 2%.

Preferably, in order to estimate the SOH of the battery bank BB more accurately, the second SOH that corrects the first SOH must be determined more accurately. In addition, since the second SOH is a value that reflects the state difference between the plurality of battery cells, the SOH table may be set by considering not only the time at which the circulating current flows but also the voltage of the battery bank BB after the circulating current flows.

The control unit 120 may determine a more accurate second SOH by inputting the time at which the circulating current flows and the voltage of the battery bank BB into the SOH table. And, since the first SOH is corrected by the determined second SOH, the control unit 120 may estimate the SOH of the battery bank BB more accurately.

Preferably, the control unit 120 estimates a first SOH of the battery bank BB each time the battery bank BB is charged, determines a second SOH based on a difference between the plurality of battery cells, and estimates the SOH of the battery bank BB based on the first SOH and the second SOH.

In another embodiment, the control unit 120 may determine the second SOH based on the difference between the first SOH estimated in the current charging process (hereinafter referred to as "current first SOH") and the SOH estimated in the previous charging process (hereinafter referred to as "previous SOH").

Specifically, the control unit 120 may be configured to determine the second SOH if the difference between the first SOH and the previously estimated SOH of the battery bank BB is greater than or equal to a preset threshold value.

If the SOH of the battery bank BB is estimated by correcting the first SOH every time the battery bank BB is charged, the SOH of the battery bank BB may be estimated more accurately. However, since the SOH correction through the second SOH is performed every time, it takes more time to estimate the SOH and system resources may be excessively used. Therefore, the control unit 120 may determine the second SOH if the difference between the current first SOH and the previous SOH is greater than or equal to the threshold value.

Here, the threshold value is a value that may be set theoretically or experimentally as a criterion for judging that the degradation of the battery bank BB has progressed and that correction of the first SOH by the second SOH is necessary. For example, the threshold value may be set to a value of SOH 10% or less. Preferably, the threshold value may be set to a value of SOH 5% or less. More preferably, the threshold value may be set to a value of SOH 1% or less.

For example, assume that the threshold value is set to SOH 1%. If the difference between the current first SOH and the previous SOH is greater than or equal to 1%, the degradation of the battery bank BB has progressed compared to the time when the previous SOH was estimated, so the control unit 120 may determine the second SOH to correct the current first SOH.

Specifically, if the difference between the current first SOH and the previous SOH is greater than or equal to the threshold value, the control unit 120 may determine the second SOH, and estimate the SOH of the battery bank BB by calculating the difference between the current first SOH and the determined second SOH. As another example, if the difference between the current first SOH and the previous SOH is less than the threshold value, the control unit 120 may estimate the current first SOH as the SOH of the battery bank BB.

The control unit 120 may be configured to update an OCV table representing a corresponding relationship between voltage and SOC of the plurality of battery cells to correspond to the SOH of the battery bank BB.

Specifically, a plurality of OCV tables corresponding to a plurality of SOHs may be stored in advance. Then, the control unit 120 may select an OCV table corresponding to the SOH of the battery bank BB among the plurality of OCV tables, and use the selected OCV table to estimate the state of the plurality of battery cells.

That is, since the OCV table is updated to correspond to the SOH of the compensated battery bank BB, the state of the plurality of battery cells may be estimated more accurately according to the updated OCV table.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the components included in the conventional BMS. For example, the measuring unit 110, the control unit 120, and the storage unit 130 of the battery management apparatus 100 may be implemented as components of the BMS.

In addition, the battery management apparatus 100 according to the present disclosure may be provided in a battery bank BB. That is, the battery bank BB according to the present disclosure may include the above-described battery management apparatus 100 and one or more battery cells. In addition, the battery bank BB may further include electrical equipment (relays, fuses, etc.) and a case.

FIG. 5 is a schematic drawing of a battery pack 1 according to another embodiment of the present disclosure.

The battery module 10 may include a plurality of battery banks 11, 12, 13 connected in series with each other. Here, each of the plurality of battery banks 11, 12, 13 may include a plurality of battery cells connected in parallel. That is, the battery module 10 may include a plurality of battery cells connected in series and in parallel.

The measuring unit 110 may be connected to the first to fourth sensing lines SL1, SL2, SL3, SL4. Specifically, the measuring unit 110 may measure the voltage of the first battery bank 11 through the first sensing line SL1 and the second sensing line SL2. In addition, the measuring unit 110 may measure the voltage of the second battery bank 12 through the second sensing line SL2 and the third sensing line SL3, and may measure the voltage of the third battery bank 13 through the third sensing line SL3 and the fourth sensing line SL4. Finally, the measuring unit 110 may measure the voltage of the battery module 10 through the first sensing line SL1 and the fourth sensing line SL4.

And, the measuring unit 110 may be connected to the current measurement unit A through the fifth sensing line SL5. For example, the current measurement unit A may be a current meter or a shunt resistor capable of measuring the charging current and discharging current of the battery module 10. The measuring unit 110 may measure the charging current of the battery module 10 through the fifth sensing line SL5 to calculate the charge amount. In addition, the measuring unit 110 may measure the discharging current of the battery module 10 through the fifth sensing line SL5 to calculate the discharge amount.

An external device may be connected to the positive electrode terminal P+ and the negative electrode terminal P- of the battery pack 1. For example, the external device may be a charging device or a load. In addition, the positive electrode terminal of the battery module 10, the positive electrode terminal P+ of the battery pack 1, the external device, the negative electrode terminal P- of the battery pack 1, and the negative electrode terminal of the battery module 10 may be electrically connected.

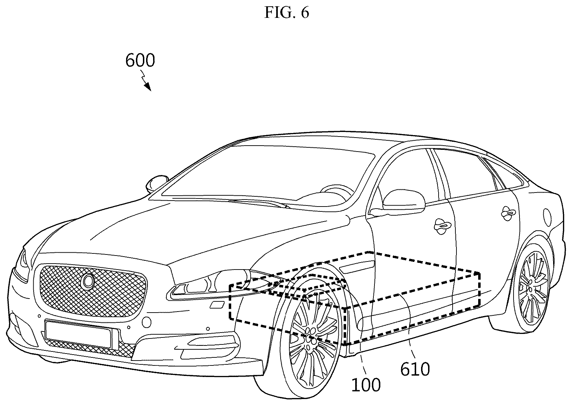

FIG. 6 is a schematic drawing of a vehicle 600 according to another embodiment of the present disclosure.

Referring to FIG. 6, the battery pack 610 according to an embodiment of the present disclosure may be included in a vehicle 600, such as an electric vehicle (EV) or a hybrid vehicle (HV). In addition, the battery pack 610 may drive the vehicle 600 by supplying power to a motor through an inverter provided in the vehicle 600. Here, the battery pack 610 may include the battery management apparatus 100. That is, the vehicle 600 may include the battery management apparatus 100. In this case, the battery management apparatus 100 may be an onboard device included in the vehicle 600.

For example, the battery pack 610 includes a plurality of battery banks BB, and the battery management apparatus 100 may estimate the SOH of each of the plurality of battery banks BB. Here, the plurality of battery banks BB connected in series with each other may be included in a battery module, and the plurality of battery modules may be included in the battery pack 610.

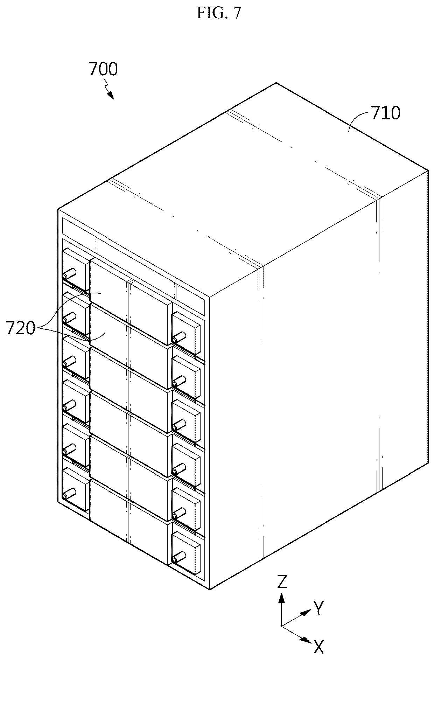

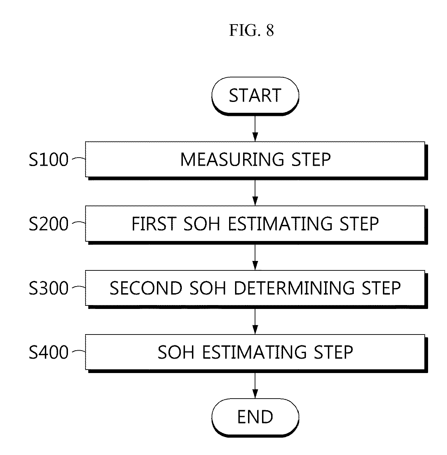

FIG. 7 is a schematic drawing of an ESS (Energy storage system) according to still another embodiment of the present disclosure.

Referring to FIG. 7, the ESS 700 includes a plurality of battery modules 720 and a rack case 710. The plurality of battery modules 720 may be configured to be accommodated in the rack case 710 in a vertically arranged form. Here, the battery management apparatus 100 according to an embodiment of the present disclosure may be attached to the battery module 720.

For example, the battery module 720 includes a plurality of battery banks BB, and the battery management apparatus 100 may estimate the SOH of each of the plurality of battery banks BB.

FIG. 8 is a diagram schematically showing a battery management method according to still another embodiment of the present disclosure.

Referring to FIG. 8, the battery management method may include a measuring step (S100), a first SOH estimating step (S200), a second SOH calculating step, and a SOH estimating step.

Preferably, each step of the battery management method may be performed by the battery management apparatus 100. Hereinafter, for convenience of explanation, contents overlapping with the previously described contents will be omitted or briefly described.

The measuring step (S100) is a step of measuring voltage and current of a battery bank BB during a charging process of the battery bank BB including a plurality of battery cells, and may be performed by the measuring unit 110.

The first SOH estimating step (S200) is a step of estimating a first SOH of the battery bank BB based on the charging capacity obtained by integrating the measured current, and may be performed by the control unit 120.

First, the control unit 120 may be configured to calculate the charging capacity of the battery bank BB by integrating the measured current. For example, the control unit 120 may calculate the charging capacity of the battery bank BB during the charging process by integrating the current measured by the measuring unit 110 from the charging start point to the charging end point of the battery bank BB.

In addition, the control unit 120 may be configured to estimate the first SOH of the battery bank BB based on the calculated charging capacity. For example, the control unit 120 may estimate the first SOH of the battery bank BB by calculating a ratio of the charging capacity to a preset reference capacity.

The second SOH determining step (S300) is a step of determining a second SOH based on the time at which a circulating current flows through the plurality of battery cells from the charging end point of the battery bank BB, and may be performed by the control unit 120.

First, the control unit 120 may be configured to calculate the time during which the circulating current flows based on the voltage of the battery bank BB from the charging end point. For example, the control unit 120 may calculate the time during which the voltage of the battery bank BB changes from the charging end point as the time during which the circulating current flows through the plurality of battery cells.

And, the control unit 120 may determine an SOH value corresponding to the calculated time using the SOH table. And, the control unit 120 may determine the determined SOH value as the second SOH for the battery bank BB.

The SOH estimating step (S400) is a step of estimating a SOH of the battery bank BB based on the first SOH and the second SOH, and may be performed by the control unit 120.

Specifically, the control unit 120 may be configured to calculate the difference between the first SOH and the second SOH to calculate a third SOH, and estimate the calculated third SOH as the SOH of the battery bank BB.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
10: battery module
11: first battery bank
12: second battery bank
13: third battery bank
100: battery management apparatus
110: measuring unit
120: control unit
130: storage unit
600: vehicle
610: battery pack
700: ESS
710: battery rack
720: battery module

## Claims

1. A battery management apparatus, comprising:
a measuring unit configured to measure voltage and current of a battery bank during a charging process of the battery bank including a plurality of battery cells; and
a control unit configured to estimate a first SOH of the battery bank based on a charging capacity obtained by integrating the measured current, determine a second SOH based on a time during which a circulating current flows through the plurality of battery cells from a charging end point of the battery bank, and estimate a SOH of the battery bank based on the first SOH and the second SOH.

2. The battery management apparatus according to claim 1,
wherein the control unit is configured to calculate a charging capacity of the battery bank by integrating the measured current and estimate the first SOH of the battery bank based on the calculated charging capacity.

3. The battery management apparatus according to claim 1,
wherein the control unit is configured to calculate the time at which the circulating current flows based on the voltage of the battery bank from the charging end point.

4. The battery management apparatus according to claim 1,
wherein the control unit is configured to determine the second SOH corresponding to the time using an SOH table in which a SOH value corresponding to the time at which the circulating current flows is preset.

5. The battery management apparatus according to claim 1,
wherein the control unit is configured to determine the second SOH corresponding to the voltage of the battery bank at the charging end point and the time by using an SOH table in which the time at which the circulating current flows and a SOH value corresponding to a voltage of the battery bank after the circulating current flows are preset.

6. The battery management apparatus according to claim 1,
wherein the control unit is configured to generate a third SOH by calculating a difference between the first SOH and the second SOH and estimate the generated third SOH as the SOH of the battery bank.

7. The battery management apparatus according to claim 1,
wherein the control unit is configured to determine the second SOH when a difference between the first SOH and a previously estimated SOH of the battery bank is greater than or equal to a preset threshold value.

8. The battery management apparatus according to claim 1,
wherein the plurality of battery cells are configured to be connected in parallel with each other.

9. A battery pack, comprising the battery management apparatus according to any one of claims 1 to 8.

10. A vehicle, comprising the battery management apparatus according to any one of claims 1 to 8.

11. A battery management method, comprising:
a measuring step of measuring voltage and current of a battery bank during a charging process of the battery bank including a plurality of battery cells;
a first SOH estimating step of estimating a first SOH of the battery bank based on a charging capacity obtained by integrating the measured current;
a second SOH determining step of determining a second SOH based on a time during which a circulating current flows through the plurality of battery cells from a charging end point of the battery bank; and
a SOH estimating step of estimating a SOH of the battery bank based on the first SOH and the second SOH.
